Europäisches Patentamt

European Patent Office

Office européen des brevets

(11) Publication number: **0 358 185 B1**

# EUROPEAN PATENT SPECIFICATION

(45) Date of publication of patent specification: **19.01.94**  (51) Int. Cl.⁵: **C30B 11/00**, C30B 29/52, C22C 19/05

(21) Application number: **89116431.1**

(22) Date of filing: **06.09.89**

(54) **Ni-base single-crystal superalloy excellent in high-temperature strength and high-temperature corrosion resistance.**

(30) Priority: **09.09.88 JP 226076/88**

(43) Date of publication of application:
**14.03.90 Bulletin 90/11**

(45) Publication of the grant of the patent:
**19.01.94 Bulletin 94/03**

(84) Designated Contracting States:
**DE FR GB**

(56) References cited:
EP-A- 0 052 911
EP-A- 0 149 942
FR-A- 2 463 192
FR-A- 2 512 837
GB-A- 2 071 695

(73) Proprietor: **MITSUBISHI MATERIALS CORPORATION**
**6-1, Otemachi 1-chome**
**Chiyoda-ku Tokyo(JP)**

Proprietor: **CENTRAL RESEARCH INSTITUTE OF ELECTRIC POWER INDUSTRY (CRIEPI)**
**6-1, Ohtemachi 1-chome**
**Chiyoda-ku Tokyo 100(JP)**

(72) Inventor: **Nitta, Akito**
**No. 19-2-202, Minamiohsawa 4-chome**
**Hachiohji-shi Tokyo(JP)**
Inventor: **Matsubara, Masaaki**
**No. 11-1-107, Kitami 9-chome**
**Setagaya-ku**
**Tokyo(JP)**
Inventor: **Wada, Kunihisa**
**No. 11-1, Nakayama 2-chome**
**Hachiohji-shi Tokyo(JP)**
Inventor: **Wakita, Saburo Chuo Kenkyusho,**
**Mitsubishi Kinzoku**
**Kabushiki Kaisha**
**No. 297, Kitabukurocho 1-chome**
**Ohmiya-shi Saitama-ken(JP)**
Inventor: **Hoshi, Junji Chuo Kenkyusho Mitsubishi Kinzoku**
**Kabushiki Kaisha**
**No. 297, Kitabukurocho 1-chome**
**Ohmiya-shi Saitama-ken(JP)**
Inventor: **Shimamura, Toshiyuki Okegawa**
**Daiichi Seisakusho**
**Mitsubishi Kinzoku K. K.**
**No. 1230, Kamihideya**
**Okegawa-shi Saitama-ken(JP)**

(74) Representative: **May, Hans Ulrich, Dr.**
**Patentanwalt Dr.H.U.May,**
**Thierschstrasse 27**
**D-80538 München (DE)**

**Description**

BACKGROUND OF THE INVENTION

This invention relates to an Ni-base single-crystal superalloy which exhibits excellent high-temperature strength and excellent high-corrosion resistance, when used as a material of blades for gas turbines, etc.

Conventionally, Ni-base single-crystal superalloys have been used as materials of blades for gas turbines or the like. Ni-base single-crystal superalloys of this kind have the advantage that since they have a single-crystalline cast structure with no crystalline grain boundary, they have no segregation of component elements. Consequently, they are free of grain growth and intergranular oxidation, which possibly occur at a low solution-treatment temperature in a casting formed of a conventional polycrystal alloy. Therefore, the casting of the Ni-base single-crystal superalloy can be heated to such a high temperature for solution treatment thereof that a $\gamma'$-phase, which is formed of an intermetallic compound typically represented by $Ni_3(Al, Ti)$, is completely resolved in solid solution in a $\gamma$-phase forming the matrix which has high high-temperature corrosion resistance. When it is subsequently cooled, the $\gamma'$-phase becomes precipitated in fine particles and dispersed evenly through the matrix in a larger amount than that in a conventional polycrystal superalloy. The resulting single-crystal superalloy has a much higher ratio of $\gamma'$-phase to the $\gamma$-phase than a conventional polycrystal superalloy, thereby possessing excellent high-temperature strength.

Various such single-crystal superalloys have been already known, e.g. from Japanese Provisional Patent Publication (Kokai) No. 56-142 842, French Patent Publication No. FR-A-2 512 837, Japanese Provisional Patent Publication (Kokai) No. 60-155 637, and European Patent Publication No. EP-A-0 149 942.

In Japanese Provisional Patent Publication No. 56-142 842, a Ni-base single-crystal superalloy is proposed, which, for example, has a composition of : 10 - 16% Cr; 4 - 16% Co; 2 - 4% Mo; 0 - 2% W; 2 - 8% Ta; 4 - 6% Al; 1 - 4% Ti; 0.015 - 0.05% C; 0 - 0.01% B; 0 - 0.01% Zr; and the balance of Ni and inevitable impurities, Ta + Mo + 1/2 W being 4 - 6%, and 1/2 Ti + Al being 5 - 7%.

The proposed superalloy according to Japanese Provisional Patent Publication No. 56-142 842 having the above composition has good corrosion resistance and good high-temperature resistance.

In FR-A-2 512 837, a Ni-base single-crystal superalloy is proposed, which has a composition of : approximately 3.5 - 7% Ta; approximately 7.5 - 11% Cr; approximately 4 - 6% Co; approximately 0.6 - 1.8% Ti; approximately 0 - 2.5% Mo; approximately 6 - 12% W; approximately 4.5 - 6% Al; approximately 0.05 - 0.5 Hf; and the balance being essentially of Ni, and preferably W being contained in less than 10%.

The Ni-base single-crystal superalloy according to FR-A-2 512 837 has a significantly reduced amount of Ta which is expensive and relatively dense and hence can be manufactured at a low cost and has low density while maintaining properties possessed by conventional Ni-base single-crystal superalloys.

In Japanese Provisional Patent Publication No. 60-155 637, a Ni-base single-crystal superalloy is proposed, which, for example, has a composition of: 8 - 15% Cr; 5 - 7% Al; 2 - 5% Ti; 0.1 - 2% Nb; 0 - 5% Mo; 1 - 8% Ta; 0 - 8% W; 5 - 15% Co; 0 - 2% V; 0 - 0.05% C; and the balance of Ni and inevitable impurities.

The Ni-base single-crystal superalloy according to Japanese Provosional Patent Publication No: 60-155 637 having the above composition has good shock resistance and good tensile ductility.

In EP-A-0 149 942, a Ni-base single-crystal superalloy is proposed, which, for example, has a densitiy of approximately 8.6 and a composition of: 6 - 8% Co; 6.5 - 8% Cr; 1 - 2.5% Mo; 5 - 8% W; 6 - 8% Ta; 5 - 5.5% Al; 1.1 - 2 Ti; 0 - 1% Nb; and the balance of Ni; the sum Ta + Mo + 1/2 W being 11.5% - 13.5%; the sum Ti + Al + Ta + Nb being 15.5 - 17 atom%; the sum Ta + Nb + Mo + 1/2 W being 4.5 - 5.5 atom%, the sum Ti + Al + Nb + Mo + 1/2 W being 17.5 - 19 atom%; and the sum Ti + Al being 12.8 - 14.4 atom%.

The Ni-base single-crystal superalloy according to EP-A-0 149 942 has good creep resistance at high temperatures.

On the other hand, blades and like parts of gas turbines have been placed under severer operating conditions because of recent increase in the rotational speed and output power of gas turbines.

However, none of the above-mentioned Ni-base single-crystal superalloys according to the prior art possess high-temperature strength and high-temperature corrosion resistance enough to withstand use under any severe operating conditions. Therefore, there is a strong demand for an Ni-base single-crystal superalloy having excellent high-temperature strength and excellent high-temperature corrosion resistance, which can withstand use as a gas turbine blades, etc. under severe operating conditions.

SUMMARY OF THE INVENTION

It is the object of the invention to provide an Ni-base single-crystal superalloy which is capable of exhibiting excellent high-temperature strength as well as excellent high-temperature corrosion resistance, when used as a material of gas turbine blades, etc.

To attain the above object, the present invention provides an Ni-base single-crystal superalloy consisting of (by weight): 9 - 11 % Cr; 0.5 - 0.8 % Mo; 5.5 - 6.8 % W; 5.2 - 6 % Ta; 5 - 6 % Al; 1.8 - 2.5 % Ti; 4.2 - 4.9 % Co; 0.05 - 0.5 % Re; and the balance of Ni and inevitable impurities.

The present invention also provides an Ni-base single-crystal superalloy consisting of (by weight): 9 - 11 % Cr; 0.5 - 0.8 % Mo; 5.5 - 6.8 % W; 5.2 - 6 % Ta; 5 - 6 % Al; 1.8 - 2.5 % Ti; 4.2 - 4.9 % Co; 0.05 - 0.5 % Re; 0.01 - 0.3 % Si; and the balance of Ni and inevitable impurities.

The above and other objects, features, and advantages of the invention will be more apparent from the ensuing detailed description.

DETAILED DESCRIPTION

Under the aforestated circumstances, the present applicants have made many studies in order to develop an Ni-base single-crystal superalloy suitable particularly for use under very severe operating conditions, and have reached the following finding:

An Ni-base single-crystal superalloy consisting of (by weight): 9 - 11 % Cr; 0.5 - 0.8 % Mo; 5.5 - 6.8 % W; 5.2 - 6 % Ta; 5 - 6 % Al; 1.8 - 2.5 % Ti; 4.2 - 4.9 % Co; 0.05 - 0.5 % Re; and the balance of Ni and inevitable impurities, which may further contain 0.01 - 0.3 % Si, if required, has far more excellent high-temperature strength and high-temperature corrosion resistance than the conventional superalloys of this kind. When the Ni-based single-crystal superalloy having the above chemical composition is used as a turbine blade for gas turbines, for example, it exhibits excellent performance even under severe environmental operating conditions over a long-term use.

The present invention is based upon the above finding, and the Ni-base single-crystal superalloy according to the invention has the aforesaid chemical compositions. Percentage is weight percent throughout the whole specification, unless otherwise specified. The chemical compositions have been limited as stated before for the following reasons:

(a) Cr:

The Cr component acts to increase the high-temperature corrosion resistance of the alloy. However, if the Cr content is less than 9 %, the above action cannot be performed to a satisfactory extent. On the other hand, if the Cr content exceeds 11 %, not only precipitation of the $\gamma$ '-phase in the alloy is suppressed but also harmful plate-like phases such as a $\sigma$-phase and a $\mu$-phase can be formed, which lower the high-temperature strength of the alloy. Therefore, the Cr content has been limited within a range of from 9 to 11 %. The preferable range of the Cr content is from 9.5 to 10.5 %.

(b) Mo:

The Mo component coacts with the W and Ta components to bring the lattice constant of the $\gamma$-phase forming the matrix to an appropriate or balanced value, which makes the structure of the resulting alloy stable and fine, thereby increasing the high-temperature strength of the alloy. If the Mo content is less than 0.5 %, the above action cannot be performed to a satisfactory extent. On the other hand, if the Mo content exceeds 0.8 %, the resulting alloy will have rather lowered high-temperature strength as well as degraded high-temperature corrosion resistance. Therefore, the Mo content has been limited within a range of from 0.5 to 0.8 %. Best results can be obtained if the Mo content is from 0.6 to 0.8 %.

(c) W:

The W component is partly resolved in solid solution in the matrix to increase the high-temperature strength of the alloy, in addition to the action described in (b). If the W content is less than 5.5 %, desirable high-temperature strengh cannot be obtained. On the other hand, if the W content exceeds 6.8 %, the resulting alloy will have lowered high-temperature corrosion resistance Therefore, the W content has been limited within a range of from 5.5 to 6.8 %. Best results can be obtained if the Mo content is from 5.7 to 6.4 %.

(d) Ta:

The Ta component is partly resolved in solid solution in the matrix to increase the high-temperature corrosion resistance of the alloy, in addition to the action of increasing the high-temperature strength in cooperation with the Mo and W components, as described in (b). If the Ta content is less than 5.2 %, the above action cannot be performed to a satisfactory extent. However, if the Ta content exceeds 6 %, the aforementioned harmful $\sigma$-phase and/or $\mu$-phase is formed in the alloy to thereby lower the high-temperature strength. Therefore, the Ta content has been limited within a range of from 5.2 to 6 %, and preferably from 5.3 to 5.8 %.

(e) Al:

The Al component combines with the Ni and Ti components to form a $\gamma$'-phase, which is formed of an intermetallic compound typically represented by $Ni_3$ (Al, Ti), usually in an amount of 50 to 60 % by volume, thereby increasing the high-temperature strength of the alloy. However, if the Al content is less than 5%, the $\gamma$'-phase is precipitated to an insufficient degree, failing to obtain desired high-temperature strength. On the other hand, if the Al content exceeds 6 %, a coarse $\gamma$'-phase, i.e., so-called eutectic $\gamma$'-phase, is formed in a large amount in the alloy, which makes it impossible to carry out solution treatment of the alloy, failing to obtain desired high-temperature strength of the alloy. Therefore, the Al content has been limited within a range of from 5 to 6 %, and preferably from 5.3 to 5.8 %.

(f) Ti:

As mentioned in (e), the Ti component combines with the Ni and Al components to increase the high-temperature strength of the alloy. If the Ti content is less than 1.8 %, the $\gamma$'-phase is not formed in a sufficient amount, making it impossible to obtain desired high-temperature strength. On the other hand, if the Ti content exceeds 2.5 %, it is impossible to carry out solution treatment so that the resulting alloy will not have a sufficient amount of fine $\gamma$'-phase dispersed throughout the matrix, thereby making it difficult to obtain desired high-temperature strength. Therefore, the Ti content has been limited within a range of from 1.8 to 2.5 %, preferably from 1.9 to 2.2 %.

(g) Co:

The Co component acts not only to enable to use a lower solution-treatment temperature but also to increase the high-temperature corrosion resistance. If the Co content is less than 4.2 %, the above action cannot be performed to a satisfactory extent. However, if the Co content exceeds 4.9 %, the $\gamma$'-phase cannot be precipitated in a sufficient amount, making it impossible to obtain desired high-temperature strength. Therefore, the Co content has been limited within a range of from 4.2 to 4.9 %, preferably from 4.3 to 4.8 %.

(h) Re:

The Re-component acts to further increase the high-temperature strength and high-temperature corrosion resistance. If the Re content is less than 0.05 %, the above action cannot be performed to a satisfactory extent. On the other hand, if the Re content exceeds 0.5 %, the resulting alloy will have degraded high-temperature strength. Therefore, the Re content has been limited within a range of from 0.05 to 0.5 %, preferably 0.05 to 0.2 %.

(i) Si:

The Si component acts to further increase the high-temperature corrosion resistance. Therefore, according to the invention, Si may be added if required. If the Si content is less than 0.01 %, the high-temperature corrosion resistance cannot be increased to a satisfactory degree. On the other hand, if the Si content exceeds 0.3 %, the resulting alloy will have lowered high-temperature strength. Therefore, the Si content has been limited within a range of from 0.01 to 0.3 %, preferably from 0.01 to 0.1 %.

An example of the Ni-base single-crystal superalloy according to the invention will now be described in detail.

5

EXAMPLE

Molten alloys having respective chemical compositions shown in Table 1 were prepared by the use of a vacuum smelting furnace. The molten alloys were each cast by the use of a directional solidification furnace into an ingot in the form of a rectangular parallelepiped having a single-crystalline cast structure and a size of 10 mm in width, 7 mm in thickness, and 95 mm in length. The ingots thus obtained were subjected to solution treatment wherein they were held in an air atmosphere at a temperature within a range of from 1240 to 1270 °C for 30 to 300 minutes, and then exposed to the air to be cooled. Then, the ingots were subjected to stabilizing treatment wherein they were held in an air atmosphere at a temperature within a range of from 950 to 1050 °C for 3 to 6 hours, and then exposed to the air to be cooled, followed by being subjected to aging wherein they were held in an air atmospere at a temperature within a range of from 850 to 900 °C for 16 to 32 hours, and then cooled by the air. Thus, Ni-base single-crystal superalloys Nos. 1 - 21 according to the invention were obtained, each having a structure in which the $\gamma$ '-phase of a fine intermetallic compound is evenly dispersed throughout the matrix of the $\gamma$-phase.

Comparative Ni-base single-crystal superalloys Nos. 1 - 17, each having a chemical composition falling within the range of the present invention, except that one of the component elements has its content (marked with an asterisk in Table) falling out of the range of the present invention, were manufactured under the same conditions as described above.

In order to evaluate the high-temperature strength, the Ni-base single-crystal superalloys Nos. 1 - 21 according to the invention and the comparative alloys Nos. 1 - 17 were subjected to a high-temperature creep rupture test wherein they were held in an air atmosphere at a temperature of 900 °C and under a load of 30 kg/mm$^2$, and were measured in respect of time period before fracture (in hour), elongation, and reduction in area. Further, to evaluate the high-temperature corrosion resistance, they were also subjected to a molten salt immersion

| | | CHEMICAL COMPOSITION (% BY WEIGHT) | | | | | | | | | | TIME PERIOD BEFORE FRACTURE (hr) | ELONGATION (%) | REDUCTION IN AREA (%) | REDUCTION IN WEIGHT (mg/cm²) |
|---|---|---|---|---|---|---|---|---|---|---|---|---|---|---|---|
| | | Cr | Mo | W | Ta | Aℓ | Ti | Co | Re | Si | Ni + IMPURITIES | | | | |
| Ni-BASE SINGLE CRYSTAL SUPERALLOY ACCORDING TO THE INVENTION | 1 | 9.05 | 0.71 | 6.30 | 5.61 | 5.42 | 2.10 | 4.58 | 0.13 | — | BAL. | 1120.0 | 28.0 | 31.9 | 8.01 |
| | 2 | 10.06 | 0.72 | 6.10 | 5.52 | 5.43 | 2.02 | 4.65 | 0.14 | — | BAL. | 1082.3 | 22.8 | 30.7 | 6.63 |
| | 3 | 10.92 | 0.68 | 6.05 | 5.46 | 5.41 | 1.98 | 4.63 | 0.11 | — | BAL. | 786.5 | 14.0 | 21.4 | 6.07 |
| | 4 | 10.10 | 0.52 | 6.01 | 5.49 | 5.45 | 2.00 | 4.57 | 0.12 | — | BAL. | 866.9 | 22.7 | 21.8 | 6.89 |
| | 5 | 9.96 | 0.78 | 6.04 | 5.56 | 5.38 | 2.14 | 4.62 | 0.16 | — | BAL. | 985.7 | 23.9 | 35.8 | 8.08 |
| | 6 | 10.14 | 0.69 | 5.56 | 5.58 | 5.44 | 2.07 | 4.66 | 0.12 | — | BAL. | 968.1 | 21.7 | 30.1 | 6.82 |
| | 7 | 10.12 | 0.68 | 6.77 | 5.64 | 5.38 | 2.01 | 4.60 | 0.11 | — | BAL. | 1048.2 | 21.7 | 30.8 | 8.04 |
| | 8 | 10.07 | 0.70 | 6.21 | 5.24 | 5.43 | 2.05 | 4.63 | 0.10 | — | BAL. | 983.7 | 23.9 | 30.8 | 8.06 |
| | 9 | 10.03 | 0.65 | 6.13 | 5.92 | 5.54 | 2.00 | 4.61 | 0.13 | — | BAL. | 988.0 | 18.1 | 25.8 | 6.32 |
| | 10 | 10.09 | 0.63 | 6.06 | 5.48 | 5.06 | 2.04 | 4.59 | 0.12 | — | BAL. | 761.8 | 25.0 | 37.7 | 8.68 |
| | 11 | 10.07 | 0.63 | 6.24 | 5.47 | 5.99 | 1.98 | 4.60 | 0.10 | — | BAL. | 755.9 | 17.2 | 25.5 | 6.87 |
| | 12 | 10.05 | 0.70 | 6.22 | 5.47 | 5.44 | 1.82 | 4.58 | 0.12 | — | BAL. | 792.5 | 24.3 | 33.0 | 8.72 |
| | 13 | 9.97 | 0.71 | 6.17 | 5.50 | 5.51 | 2.48 | 4.61 | 0.14 | — | BAL. | 767.9 | 21.9 | 29.7 | 6.48 |
| | 14 | 9.99 | 0.72 | 6.12 | 5.51 | 5.40 | 2.02 | 4.22 | 0.11 | — | BAL. | 976.5 | 21.3 | 32.7 | 8.59 |
| | 15 | 10.07 | 0.72 | 6.22 | 5.49 | 5.42 | 2.01 | 4.88 | 0.12 | — | BAL. | 966.3 | 21.1 | 29.7 | 6.53 |
| | 16 | 10.11 | 0.69 | 6.17 | 5.48 | 5.38 | 1.99 | 4.66 | 0.052 | — | BAL. | 967.4 | 28.8 | 31.1 | 7.49 |
| | 17 | 10.07 | 0.71 | 6.20 | 5.52 | 5.44 | 2.09 | 4.65 | 0.49 | — | BAL. | 1031.5 | 23.5 | 29.7 | 5.92 |
| | 18 | 9.95 | 0.70 | 6.18 | 5.49 | 5.46 | 2.00 | 4.61 | 0.11 | 0.013 | BAL. | 1048.6 | 21.5 | 27.4 | 6.23 |
| | 19 | 10.03 | 0.73 | 6.19 | 5.52 | 5.37 | 1.89 | 4.63 | 0.12 | 0.12 | BAL. | 1008.1 | 20.8 | 26.3 | 6.07 |
| | 20 | 10.01 | 0.67 | 6.11 | 5.49 | 5.40 | 1.99 | 4.60 | 0.13 | 0.20 | BAL. | 850.3 | 20.0 | 25.9 | 5.82 |
| | 21 | 10.12 | 0.69 | 6.23 | 5.51 | 5.44 | 2.01 | 4.67 | 0.11 | 0.29 | BAL. | 739.1 | 19.5 | 23.7 | 5.74 |

T A B L E   (1/2)

TABLE (2/2)

| | CHEMICAL COMPOSITION (% BY WEIGHT) | | | | | | | | | | TIME PERIOD BEFORE FACTURE (hr) | ELONGATION (%) | REDUCTION IN AREA (%) | REDUCTION IN WEIGHT (mg/cm²) |
|---|---|---|---|---|---|---|---|---|---|---|---|---|---|---|
| | Cr | Mo | W | Ta | Aℓ | Ti | Co | Re | Si | Ni + IMPURITIES | | | | |
| COMPARATIVE ALLOY 1 | 8.13※ | 0.68 | 6.14 | 5.52 | 5.40 | 2.03 | 4.55 | 0.12 | — | BAL. | 1168.2 | 24.7 | 33.1 | 11.44 |
| 2 | 12.04※ | 0.75 | 6.27 | 5.55 | 5.39 | 2.00 | 4.60 | 0.09 | — | BAL. | 651.8 | 27.4 | 42.1 | 5.64 |
| 3 | 10.00 | 0.24※ | 6.24 | 5.60 | 5.42 | 1.98 | 4.62 | 0.11 | — | BAL. | 676.6 | 25.5 | 34.1 | 6.51 |
| 4 | 10.02 | 0.96※ | 6.27 | 5.49 | 5.44 | 1.95 | 4.59 | 0.12 | — | BAL. | 680.0 | 21.5 | 29.3 | 10.41 |
| 5 | 10.11 | 0.65 | 4.10※ | 5.47 | 5.45 | 2.04 | 4.64 | 0.09 | — | BAL. | 659.6 | 19.3 | 20.6 | 6.67 |
| 6 | 10.05 | 0.67 | 7.24※ | 5.54 | 5.50 | 2.01 | 4.56 | 0.08 | — | BAL. | 1042.0 | 20.7 | 26.0 | 11.90 |
| 7 | 9.97 | 0.68 | 6.19 | 4.33※ | 5.48 | 2.11 | 4.57 | 0.13 | — | BAL. | 675.3 | 27.8 | 30.5 | 10.82 |
| 8 | 10.04 | 0.64 | 6.05 | 6.85※ | 5.50 | 2.08 | 4.61 | 0.12 | — | BAL. | 684.9 | 28.8 | 31.2 | 6.20 |
| 9 | 10.08 | 0.70 | 6.06 | 5.62 | 3.21※ | 2.04 | 4.55 | 0.11 | — | BAL. | 615.4 | 31.1 | 40.5 | 10.50 |
| 10 | 9.89 | 0.64 | 6.41 | 5.57 | 7.27※ | 1.97 | 4.57 | 0.13 | — | BAL. | 638.0 | 21.0 | 19.4 | 6.60 |
| 11 | 9.97 | 0.63 | 6.52 | 5.53 | 5.51 | 1.61※ | 4.59 | 0.09 | — | BAL. | 628.2 | 30.4 | 38.7 | 9.11 |
| 12 | 10.10 | 0.60 | 6.33 | 5.50 | 5.44 | 2.74※ | 4.60 | 0.08 | — | BAL. | 677.5 | 28.5 | 31.3 | 6.59 |
| 13 | 10.03 | 0.67 | 6.27 | 5.51 | 5.45 | 2.05 | 3.13※ | 0.12 | — | BAL. | 830.5 | 25.6 | 28.3 | 11.63 |
| 14 | 10.08 | 0.64 | 6.13 | 5.67 | 5.39 | 2.00 | 5.94※ | 0.12 | — | BAL. | 684.4 | 29.8 | 29.2 | 6.62 |
| 15 | 9.97 | 0.65 | 6.09 | 5.49 | 5.51 | 2.11 | 4.61 | —※ | — | BAL. | 749.5 | 27.8 | 34.6 | 11.55 |
| 16 | 9.98 | 0.63 | 6.07 | 5.63 | 5.42 | 2.13 | 4.63 | 0.74※ | — | BAL. | 628.3 | 26.4 | 27.7 | 6.81 |
| 17 | 10.05 | 0.68 | 6.11 | 5.57 | 5.46 | 2.03 | 4.58 | 0.13 | 0.59※ | BAL. | 582.6 | 11.8 | 17.5 | 7.91 |

test wherein a test piece having a size of 10 mm in diameter and 6mm in height was immersed, for 15 minutes, in a bath of molten salt which has a composition of $Na_2SO_4$: 75 %, and $Na_2CO_3$: 25 %, in an amount of 50 g, heated to a temperature of 900 °C, followed by being descaled. Then, the test pieces were measured in respect of reduction in weight. The measuring results of the two tests are shown in Table.

It will be learned from Table that the Ni-based single-crystal superalloys Nos. 1 - 21 according to the invention show excellent high-temperature strength as well as excellent high-temperature corrosion resistance, whereas the comparative alloys Nos. 1-17, each of which has an element whose content falls out of the range of the present invention, each show inferior high-temperature strength and/or inferior high-temperature corrosion resistance.

**Claims**

1. An Ni-base single-crystal superalloy consisting of, by weight percentage: 9-11 % Cr; 0,5-0,8 % Mo; 5.5 - 6.8 % W; 5.2 - 6 % Ta; 5 - 6 % Al; 1.8 - 2.5 % Ti; 4.2 - 4.9 % Co; 0.05 - 0.5 % Re; and the balance of Ni and inevitable impurities.

2. An Ni-base single-crystal superalloy as claimed in claim 1, wherein 9.5 - 10.5 % Cr; 0.6 - 0.8 % Mo; 5.7 - 6.4 % W; 5.3 - 5.8 % Ta; 5.3 - 5.8 % Al; 1.9 - 2.2 % Ti; 4.3 - 4.8 % Co; and 0.05 - 0.2 % Re are contained.

3. An Ni-base single-crystal superalloy consisting of, by weight percentage,9 - 11 % Cr; 0,5 - 0,8 % Mo; 5.5 - 6.8 % W; 5.2 - 6 % Ta; 5 - 6 % Al; 1.8 - 2.5 % Ti; 4.2 - 4.9 % Co; 0.05 - 0.5 % Re; 0.01 - 0.3 % Si; and the balance of Ni and inevitable impurities.

4. An Ni-base single-crystal superalloy as claimed in claim 3, wherein 9.5 - 10.5 % Cr; 0.6 - 0.8 % Mo; 5.7 - 6.4 % W; 5.3 - 5.8 % Ta; 5.3 - 5.8 % Al; 1.9 - 2.2 % Ti; 4.3 - 4.8 % Co; 0.05 - 0.2 % Re; and 0.01 - 0.1 % Si are contained.

**Patentansprüche**

1. Einkristall-Superlegierung auf Nickelbasis, bestehend aus in Gewichtsprozent: 9 - 11 % Cr; 0,5 - 0,8 % Mo; 5,5 - 6,8 % W; 5,2 - 6 % Ta; 5 - 6 % Al; 1,8 - 2,5 % Ti; 4,2 - 4,9 % Co; 0,05 - 0,5 % Re und Rest Ni und unvermeidbare Verunreinigungen.

2. Einkristall-Superlegierung auf Nickelbasis nach Anspruch 1, enthaltend 9,5 - 10,5 % Cr; 0,6 - 0,8 % Mo, 5,7 - 6,4 % W; 5,3 - 5,8 % Ta; 5,3 - 5,8 % Al; 1,9 - 2,2 % Ti; 4,3 - 4,8 % Co; und 0,05 - 0,2 % Re.

3. Einkristall-Superlegierung auf Nickelbasis bestehend aus in Gewichtsprozent 9 - 11 % Cr; 0,5 - 0,8 % Mo; 5,5 - 6,8 % W; 5,2 - 6 % Ta; 5 - 6 % Al; 1,8 - 2,5 % Ti; 4,2 - 4,9 % Co; 0,05 - 0,5 % Re; 0,01 - 0,3 % Si und Rest Ni und unvermeidbare Verunreinigungen.

4. Einkristall-Superlegierung auf Nickelbasis nach Anspruch 3 enthaltend 9,5 - 10,5 % Cr; 0,6 - 0,8 % Mo; 5,7 - 6,4 % W; 5,3 - 5,8 % Ta, 5,3 - 5,8 % Al; 1,9 - 2,2 % Ti; 4,3 - 4,8 % Co; 0,05 - 0,2 % Re; und 0,01 - 0,1 % Si.

**Revendications**

1. Un superalliage monocristallin à base de Ni constitué de, en pourcentage en poids : 9-11 % de Cr; 0,5-0,8 % de Mo; 5,5-6,8 % de W; 5,2-6 % de Ta; 5-6 % de Al; 1,8-2,5 % de Ti; 4,2-4,9 % de Co; 0,05-0,5 % de Re; et le restant étant constitué de Ni et des impuretés inévitables.

2. Un superalliage monocristallin à base de Ni selon la revendication 1, selon laquelle il contient : 9,5-10,5 % de Cr; 0,6-0,8 % de Mo; 5,7-6,4 % de W; 5,3-5,8 % de Ta; 5,3-5,8 % de Al; 1,9-2,2 % de Ti; 4,3-4,8 % de Co; et 0,05-0,2 % de Re.

3. Un superalliage monocristallin à base de Ni constitué de, en pourcentage en poids : 9-11 % de Cr; 0,5-0,8 % de Mo; 5,5-6,8 % de W; 5,2-6 % de Ta; 5-6 % de Al; 1,8-2,5 % de Ti; 4,2-4,9 % de Co; 0,05-0,5 % de Re; 0,01-0,3 % de Si; et le restant étant du Ni et des impuretés inévitables.

4. Un superalliage monocristallin à base de Ni selon la revendication 3, selon laquelle il contient : 9,5-10,5 % de Cr; 0,6-0,8 % de Mo; 5,7-6,4 % de W; 5,3-5,8 % de Ta; 5,3-5,8 % de Al; 1,9-2,2 % de Ti; 4,3-4,8 % de Co; 0,05-0,2 % de Re; et 0,01-0,1 % de Si.